# EUROPEAN PATENT APPLICATION

(11) **EP 3 890 121 A1**
(43) Date of publication of application: **06.10.2021**
(21) Application number: 19891046.5
(22) Date of filing: 13.11.2019
(51) Int. Cl.: H01R 13/642, H01R 13/629

(54) **SINGLE-PLATE GUIDE SLEEVE AND SINGLE PLATE APPARATUS HAVING GUIDE SLEEVE**

(30) Priority: 26.11.2018 CN 201811429688
(71) Applicant: ZTE Corporation, Shenzhen, Guangdong 518057 (CN)
(72) Inventor: WANG, Yinghua, Shenzhen, Guangdong 518057 (CN); LIU, Chenyang, Shenzhen, Guangdong 518057 (CN); CHEN, Weiming, Shenzhen, Guangdong 518057 (CN); XIA, Runsheng, Shenzhen, Guangdong 518057 (CN)
(74) Representative: Ipsilon
(86) International application number: PCT/CN2019/117847
(87) International publication number: WO 2020/108295

(57) **Abstract**

The present disclosure provides a guide sleeve for single board and a single board device having the guide sleeve. The guide sleeve for single board includes a body which is provided in the middle thereof with a location hole for insertion of a guide pin, wherein an inclined step is arranged on a circumferential side of one end of the location hole, a protruding structure is arranged from an inner wall of the location hole and extends along a radial direction, and the protruding structure includes two inclined surfaces which are connected.

## Description

The present disclosure claims the priority of the Chinese Patent Application No.201811429688.X entitled "Guide Sleeve for Single Board and Single Board Device Having Guide Sleeve" filed on November 26, 2018, the entire contents of which are incorporated herein by reference.

### TECHNICAL FIELD

The present disclosure relates to the technical field of a single board of a network communication device, and in particular, to a guide sleeve for single board and a single board device having the guide sleeve.

### BACKGROUND

In a chassis of an electronic device, especially a chassis of a communication device, a single board and an external connector disposed corresponding to a backplane are inserted mutually to realize the board-to-board communication.

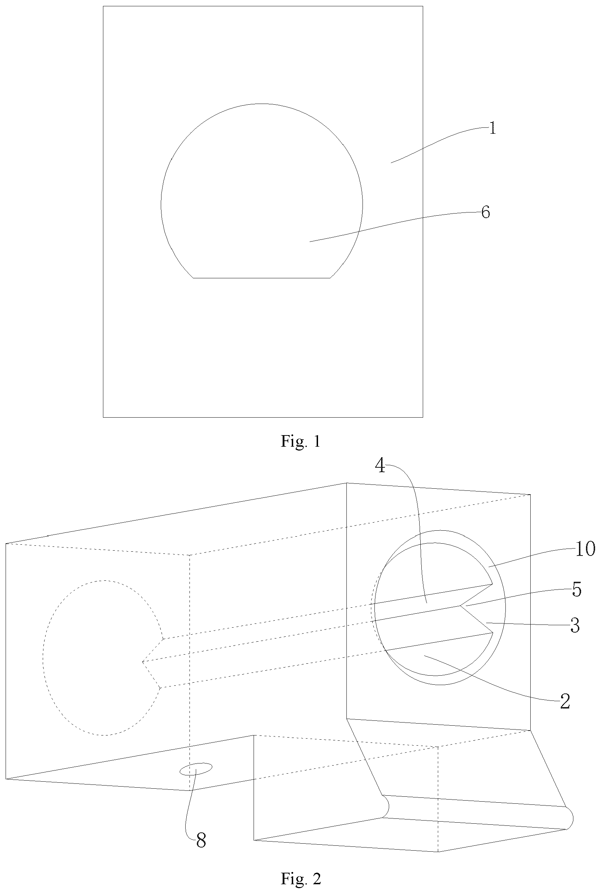

In some cases, misinsertion of a single board in a chassis is generally prevented by designing a guide sleeve 6 and a matched guide pin 7 on the single board and the backplane, respectively. As shown in Fig. 1, an anti-misinsertion structure of the guide sleeve 6 is a straight-line structure as seen from a section of the guide sleeve 6, the guide sleeve 6 and the guide pin 7 are matched in a one-to-one manner, and slots and single boards are also configured in one-to-one correspondence, which limits system configuration capacity. For example, if a backplane is provided with eight slots for single boards, in which each slot is provided with a guide pin of a fixed direction, two slots are for swap boards, one slot is for a monitoring board, and one slot is for a power board, then only four slots are left for service boards. If more service boards are required to be added to the backplane to improve system configuration, the addition is limited. If different single boards adopt the same pair of guide sleeve 6 and guide pin 7, effective anti-misinsertion is hard to be achieved; but if replacing the guide sleeve 6 for the same single board on site is adopted, the problems of difficult engineering maintenance, high maintenance cost and easy misinsertion may be caused.

### SUMMARY

The main objective of the present disclosure is to provide a guide sleeve for single board, so as to realize an anti-misinsertion function, enhance adaptability of single board, improve flexibility and usability of system configuration and system configuration capacity, and reduce maintenance cost.

In order to achieve the above objective, the guide sleeve for single board provided by the present disclosure includes a body provided in the middle thereof with a location hole for insertion of a guide pin, an inclined step is arranged on a circumferential side of one end of the location hole, a protruding structure is arranged from an inner wall of the location hole and extends along a radial direction, and the protruding structure includes two inclined surfaces which are connected.

The present disclosure further provides a single board device having a guide sleeve, including a single board and the above guide sleeve for single board, and the guide sleeve is connected with the single board through a connection structure.

In the present disclosure, the guide sleeve for single board includes a body which is provided in the middle thereof with a location hole for insertion of a guide pin, an inclined step is arranged on a circumferential side of one end of the location hole, a protruding structure is arranged from an inner wall of the location hole and extends along a radial direction, and the protruding structure includes two inclined surfaces which are connected.

### BRIEF DESCRIPTION OF THE DRAWINGS

Fig. 1 is a schematic structural diagram of a section of a guide sleeve for single board in some cases;
Fig. 2 is a schematic structural diagram of a guide sleeve for single board according to an embodiment of the present disclosure;
Fig. 3 is a schematic structural diagram of a section of a guide sleeve for single board according to an embodiment of the present disclosure;
Fig. 4a is a schematic diagram of a section of a first guide sleeve when a first guide pin is matched with and inserted in the first guide sleeve according to an embodiment of the present disclosure;
Fig. 4b is a schematic diagram of a section of the first guide sleeve when a second guide pin is matched with and inserted in the first guide sleeve according to an embodiment of the present disclosure;
Fig. 5a is a schematic diagram of a section of a second guide sleeve when the second guide pin is matched with and inserted in the second guide sleeve according to another embodiment of the present disclosure;
Fig. 5b is a schematic diagram of a section of the second guide sleeve when a third guide pin is matched with and inserted in the second guide sleeve according to another embodiment of the present disclosure;
Fig. 6 is a schematic structural diagram of a section of a guide sleeve for single board according to still another embodiment of the present disclosure;
Fig. 7 is a schematic structural diagram of a section of a guide sleeve for single board according to still yet another embodiment of the present disclosure;
Fig. 8 is a side view of a single board device according to the present disclosure; and
Fig. 9 is a front view of a guide sleeve for single board according to the present disclosure.

### Reference numerals:

| | | | |
|---|---|---|---|
| body 1 | location hole 2 | protruding structure 3 | inclined surface 4 |
| included angle 5 | guide sleeve 6 | first guide sleeve 61 | second guide sleeve 62 |
| guide pin 7 | first guide pin 71 | second guide pin 72 | third guide pin 73 |
| connection structure 8 | single board 9 | inclined step 10 | |

The achievement of the objective, the features and the advantages of the present disclosure will be further described in conjunction with the embodiments and the accompanying drawings.

### DETAILED DESCRIPTION

The technical solutions of the present disclosure are further described below in conjunction with the accompanying drawings and the embodiments. It should be understood that the embodiments described herein are merely intended to explain the present disclosure and are not intended to limit the present disclosure.

The present disclosure provides a guide sleeve for single board allowing insertion of two kinds of guide pins having different orientations, which realizes an anti-misinsertion (fool proof) function, enhances the adaptability of single board and improves the flexibility and the usability of system configuration, thereby improving the system configuration capacity. Moreover, the traditional way of replacing a guide sleeve for the same single board is changed, thereby reducing the maintenance cost.

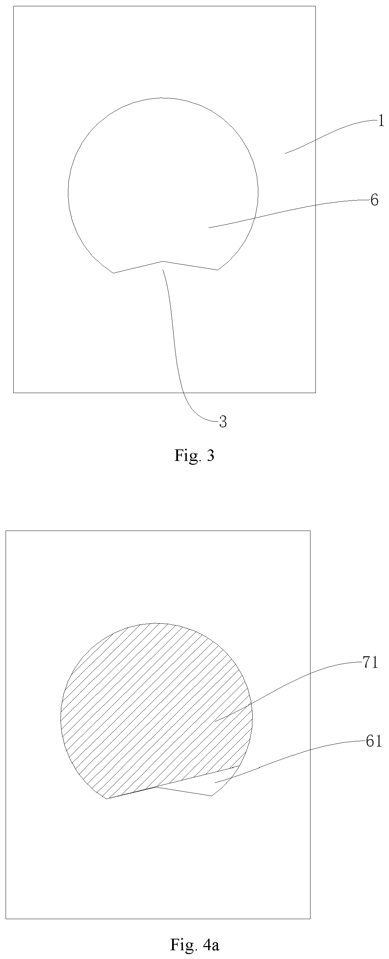

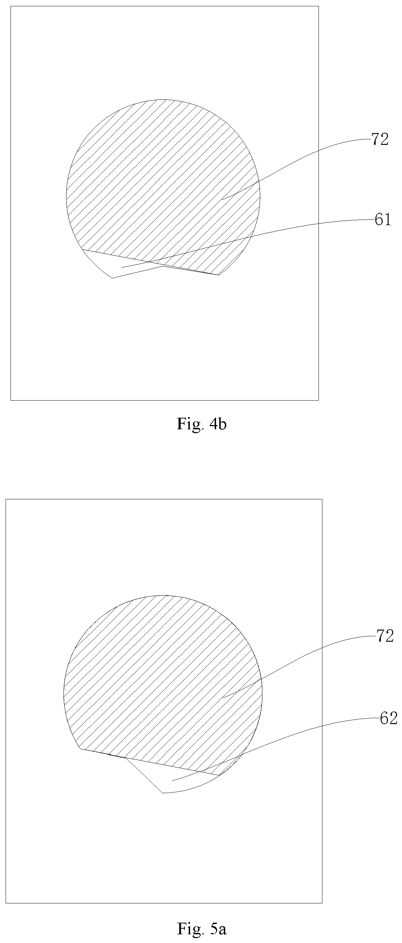

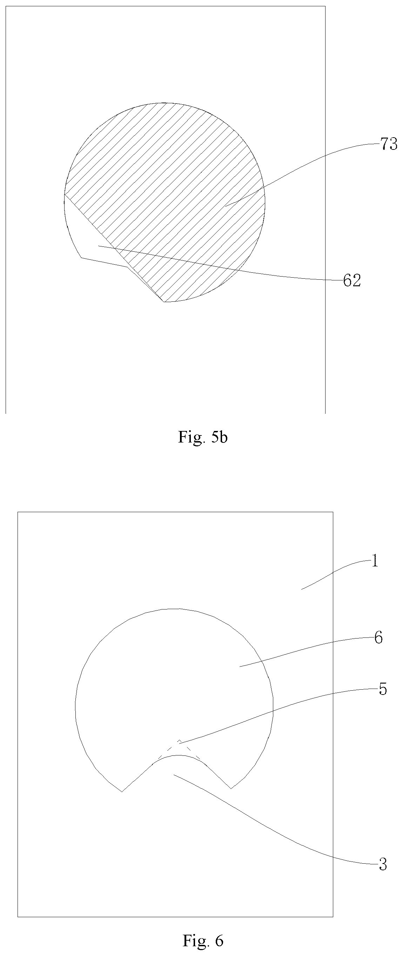

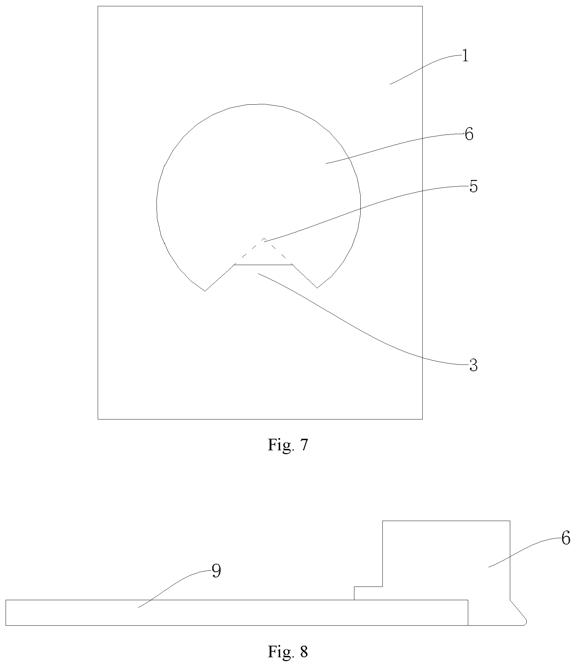

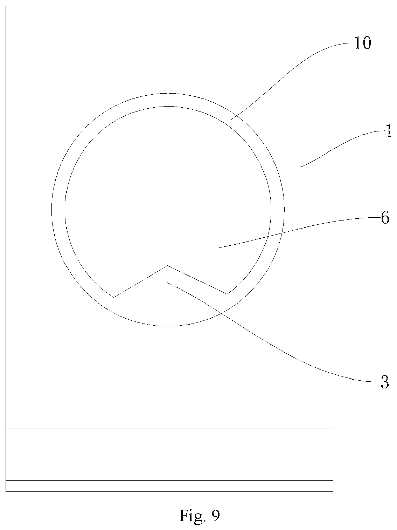

With reference to Figs. 2 to 5b, Fig. 2 is a schematic structural diagram of a guide sleeve for single board according to an embodiment of the present disclosure; Fig. 3 is a schematic structural diagram of a section of a guide sleeve for single board according to an embodiment of the present disclosure; Fig. 4a is a schematic diagram of a section of a first guide sleeve 71 when a first guide pin 71 is matched with and inserted in the first guide sleeve 61 according to an embodiment of the present disclosure; Fig. 4b is a schematic diagram of a section of the first guide sleeve 71 when a second guide pin 72 is matched with and inserted in the first guide sleeve 61 according to an embodiment of the present disclosure; Fig. 5a is a schematic diagram of a section of a second guide sleeve 62 when the second guide pin 72 is matched with and inserted in the second guide sleeve 62 according to another embodiment of the present disclosure; Fig. 5b is a schematic diagram of a section of the second guide sleeve 62 when a third guide pin 73 is matched with and inserted in the second guide sleeve 62 according to another embodiment of the present disclosure; Fig. 6 is a schematic structural diagram of a section of a guide sleeve for single board according to still another embodiment of the present disclosure; Fig. 7 is a schematic structural diagram of a section of a guide sleeve for single board according to yet another embodiment of the present disclosure; Fig. 8 is a side view of a single board device according to the present disclosure; and Fig. 9 is a front view of a guide sleeve for single board according to the present disclosure.

In an embodiment of the present disclosure, a guide sleeve for single board includes a body 1 provided in the middle thereof with a location hole 2 for insertion of a guide pin 7, an inclined step is arranged on a circumferential side of one end of the location hole, a protruding structure 3 is arranged from an inner wall of the location hole 2 and extends along a radial direction, and the protruding structure 3 includes two inclined surfaces 4 which are connected, as shown in Figs. 2 and 3.

According to the technical solution of the present application, the body 1 is provided in the middle thereof with the location hole 2 for insertion of the guide pin 7, and the inclined step is arranged on the circumferential side of one end of the location hole, so that the inclined step can perform a function of initial guide when the guide pin is inserted into the location hole. The protruding structure 3 is arranged from the inner wall of the location hole 2 and extends along the radial direction, and the protruding structure can be continuously arranged from the inner wall of the location hole along an axial direction, or can be discontinuously arranged from the inner wall of the location hole along an axial direction, or can be arranged at two ends of the inner wall of the location hole along an axial direction. The protruding structure 3 includes two inclined surfaces 4 which are connected, and the inclined surfaces can include inclined planes and inclined curved surfaces, and can also include surfaces in other shapes, which are derived from the inclined surfaces.

With the guide pin 7 fixed by the combination of the inclined surface 4 of the protruding structure 3 and the inner wall of the location hole 2, each location hole 2 can fix two kinds of guide pins 7 having different orientations. The protruding structure 3 can be arranged at any position of the inner wall of the location hole 2 and extend along different radial directions, so that the guide sleeve and the guide pin 7 can be matched in various ways, and each guide sleeve 7 can adapt to two kinds of guide sleeves having different orientations, that is, adapt to two kinds of single boards having different orientations, thereby achieving slot sharing and reducing special slots. For example, the guide sleeve includes a first guide sleeve 61 and a second guide sleeve 62, the guide pin includes a first guide pin 71, a second guide pin 72 and a third guide pin 73; as shown in Figs. 4a and 4b, the orientation of the protruding structure 3 of the first guide sleeve 61 is arranged such that the first guide pin 71 and the second guide pin 72 having different orientations can be inserted in the first guide sleeve 61; and as shown in Figs. 5a and 5b, the orientation of the protruding structure 3 of the second guide sleeve 62 is arranged such that the second guide pin 72 and the third guide pin 73 having different orientations can be inserted in the second guide sleeve 62. When a slot is provided with the second guide pin 72, insertion of the first guide sleeve 61 and insertion of the second guide sleeve 62 are allowed. If a guide pin of a slot in a backplane has a fixed orientation, a swap board is provided with the first guide sleeve 61 and a service board is provided with the second guide sleeve 62, then the slot in the backplane can allow insertion of the swap board and also allow insertion of the service board, which enhances the adaptability of single board and improves the flexibility and the usability of system configuration, thereby improving the system configuration capacity. Moreover, the traditional way of replacing a guide sleeve for the same single board is changed, thereby reducing the maintenance cost. By matching the orientation of the protruding structure of the guide sleeve with the guide pin, an anti- misinsertion (fool proof) function can be achieved.

In an embodiment, an included angle between the two inclined surfaces 4 ranges from 105 degrees to 135 degrees.

The two inclined surfaces 4 are connected, and the included angle between the two inclined surfaces ranges from 105 degrees to 135 degrees, so that the guide pin 7 can be inserted in the guide sleeve more tightly. When a junction of the two inclined surfaces is a straight line, the included angle between the two inclined surfaces is an angle formed by the two intersecting inclined surfaces; and when the two inclined surfaces are connected through a cambered surface or a flat surface, the included angle between the two inclined surfaces is an angle formed by the two extending intersecting inclined surfaces. For example, in the case where the included angle is 120 degrees, when the guide pin 7 is fixed by one inclined surface 4 of the location hole 2, an included angle between the guide pin 7 and the other inclined surface 4 is 120 degrees; and when the guide pin 7 is fixed by the other inclined surface 4, an included angle between the guide pin 7 and the one inclined surface 4 is 120 degrees. In the case where the included angle is 130 degrees, when the guide pin 7 is fixed by one inclined surface 4 of the location hole 2, an included angle between the guide pin 7 and the other inclined surface 4 is 130 degrees; and when the guide pin 7 is fixed by the other inclined surface 4, an included angle between the guide pin 7 and the one inclined surface 4 is 130 degrees. It should be understood by those of ordinary skill in the art that the above angles are merely examples, and the present disclosure is not limited thereto. With the included angles in such range, a relative small gap is left after the guide pin 7 is inserted in the guide sleeve, which ensures tight conjunction of the guide pin 7 and the inner wall.

In an embodiment, the junction of the two inclined surfaces 4 is a straight line, the protruding structure 3 has a triangular section, and the two inclined surfaces 4 have a same width or have different widths. In the embodiment of the present disclosure, the two inclined surfaces 4 can be connected to form a straight line at the junction, and the protruding structure 3 has a triangular section. The section of the protruding structure 3 is in a shape of an isosceles triangle or an equilateral triangle when the two inclined surfaces 4 have a same width, and the section of the protruding structure 3 is in a shape of a non-equilateral triangle when the two inclined surfaces 4 have different widths.

In an embodiment, the two inclined surfaces 4 are connected through a cambered surface, as shown in Fig. 6. The two inclined surfaces 4 have a same width or have different widths.

In the embodiment of the present disclosure, the two inclined surfaces 4 are connected through a single cambered surface. The two inclined surfaces 4 can be set to have a same width or have different widths.

In an embodiment, the two inclined surfaces 4 are connected through a flat surface, as shown in Fig. 7. The two inclined surfaces 4 have a same width or have different widths.

In the embodiment of the present disclosure, the two inclined surfaces 4 can be connected through a single flat surface. The two inclined surfaces 4 can be set to have a same width, or have different widths.

In an embodiment, the location hole 2 is a threaded hole, and the two inclined surfaces 4 are provided with a thread structure.

In the embodiment where the location hole 2 is a threaded hole and the two inclined surfaces 4 of the protruding structures 3 are provided with a thread structure, the guide pin 7 can be a screw to be matched with the location hole to combine a single board with a backplane.

In an embodiment, the location hole 2 is an unthreaded hole, and the two inclined surfaces 4 are smooth surfaces.

In the embodiment where the location hole 2 is an unthreaded hole and the two inclined surfaces 4 of the protruding structure 3 are smooth surfaces, the guide pin 7 can be a rivet to be matched with the location hole to combine a single board with a backplane.

In an embodiment, a side portion of the body 1 is provided with a connection structure 8 to be connected with a single board 9.

The side portion of the body 1 is provided with the connection structure 8, through which the body 1 is connected with the single board 9.

The present disclosure further provides a single board device having a guide sleeve, including the single board 9 and the guide sleeve for single board 6. As shown in Fig. 8, reference can be made to the above embodiments for the structure of the guide sleeve 6. Since the single board device adopts all the technical solutions of the above embodiments, the single board device has all the beneficial effects brought by the technical solutions of the above embodiments, which will not be repetitively described herein.

The guide sleeve is connected with the single board through the connection structure 8.

It should be noted that the technical solutions of the embodiments of the present disclosure may be combined with each other based on the fact that the combination can be enabled by those of ordinary skill in the art. If a combination of the technical solutions leads to a conflict or cannot be enabled, such combination should be considered nonexistent, and should not be considered to fall within the protection scope claimed by the present disclosure.

The technical solutions of the present disclosure realize an anti-misinsertion (fool proof) function, enhance the adaptability of single board and improve the flexibility and the usability of system configuration, thereby improving the system configuration capacity and reducing the maintenance cost.

According to the above technical solutions of the present disclosure, when the guide pin is inserted in the location hole of the guide sleeve for single board, the inclined step at an end of the location hole has the function of initial guide, and the guide sleeve can allow insertion of two kinds of guide pins having different orientations, which realizes an anti-misinsertion (fool proof) function, enhances the adaptability of single board and the flexibility and the usability of system configuration, thereby improving the system configuration capacity. Moreover, the traditional way of replacing a guide sleeve for the same single board is changed, thereby reducing the maintenance cost.

The embodiments described above are merely preferred embodiments of the present disclosure, and the scope of the present disclosure is not limited thereto. All equivalent structural changes made by using the description and drawings of the present disclosure, or the direct or indirect application of the present disclosure to any other related technical fields, are all included in the protection scope of the present disclosure for the same reason.

## Claims

1. A guide sleeve for single board, comprising a body provided in the middle with a location hole for insertion of a guide pin, wherein
an inclined step is arranged on a circumferential side of an end of the location hole,
a protruding structure is arranged from an inner wall of the location hole and extends along a radial direction, and
the protruding structure comprises two inclined surfaces which are connected.

2. The guide sleeve for single board according to claim 1, wherein an included angle between the two inclined surfaces ranges from 105 degrees to 135 degrees.

3. The guide sleeve for single board according to claim 2, wherein a junction of the two inclined surfaces is a straight line, and the protruding structure has a triangular section.

4. The guide sleeve for single board according to claim 2, wherein the two inclined surfaces are connected through a cambered surface.

5. The guide sleeve for single board according to claim 2, wherein the two inclined surfaces are connected through a flat surface.

6. The guide sleeve for single board according to any one of claims 1 to 5, wherein the two inclined surfaces have a same width.

7. The guide sleeve for single board according to claim 1, wherein the location hole is a threaded hole, and the two inclined surfaces are provided with a thread structure.

8. The guide sleeve for single board according to claim 1, wherein the location hole is an unthreaded hole, and the two inclined surfaces are smooth surfaces.

9. The guide sleeve for single board according to claim 1, wherein a side portion of the body is provided with a connection structure to be connected with the single board.

10. A single board device having a guide sleeve, comprising the single board and the guide sleeve according to any one of claims 1 to 9, wherein the guide sleeve is connected with the single board through a connection structure.
